# EUROPEAN PATENT APPLICATION

(11) **EP 1 691 421 A1**
(43) Date of publication of application: **16.08.2006**
(21) Application number: 05075331.8
(22) Date of filing: 10.02.2005
(51) Int. Cl.: H01L 31/0224, C23C 14/14, C23C 14/08, C23C 14/58, C23C 16/06, C23C 16/40, C23C 16/56

(54) **Process for preparing a metal film on a substrate**

(71) Applicant: Nederlandse Organisatie voor Toegepast-Natuurwetenschappelijk Onderzoek TNO, 2628 VK Delft (NL)
(72) Inventor: Zijp, Johannes Petrus, 5062 AT Oisterwijk (NL); Linden, Joannes Leonard, 5614 AC Eindhoven (NL)
(74) Representative: Winckels, Johannes Hubertus F.

(57) **Abstract**

The invention provides a process for preparing a metal film on a substrate, comprising the steps of:
(a) depositing a film of a metal oxide on a substrate by means of a gas phase deposition process, which metal is selected from the group consisting of Mo, V, W, Pd, Ru, Ta, Nb and Cr; and
(b) reducing the metal oxide on the substrate into the corresponding metal by contacting the film of the metal oxide with a reducing gas at a temperature in the range of from 300 to 1500°C. The invention further provides a substrate onto which a metal film is applied, which metal film is obtainable by the process according to the invention, and a solar cell comprising such a substrate.

## Description

The present invention relates to a process for preparing a metal film on a substrate, a substrate onto which the metal film is applied, and a solar cell comprising a back electrode layer, which comprises the metal film obtainable by the present process.

Thin metal films are commonly used as back electrode layers in solar cells. Heavy metals such as molybdenum or tungsten are usually applied for this purpose because of their high melting point and their high-temperature strength. When a film of such a heavy metal is used as a back electrode layer in a solar cell, the metal is applied to a substrate by means of a conventional sputtering process. Such a sputtering process has, however, the drawback that it is rather slow. Another way of applying such a heavy metal on a substrate could possibly be by means of an evaporation process. Thermal evaporation of a heavy metal such as molybdenum is, however, not a suitable alternative in view of the low vapour pressure of such metals. It is therefore desirable, especially for high volume production, to develop an alternative, and more suitable process for the preparation of a film of a heavy metal on a substrate.

Object of the invention is to provide such a process. Surprisingly, it has now been found that excellent thin metal films can be applied on a substrate when use is made of a gas phase deposition process in combination with a reduction step.

Accordingly, the present process relates to a process for preparing a metal film on a substrate, comprising the steps of:
(a) depositing a film of a metal oxide on a substrate by means of a gas phase deposition process, which metal is selected from the group consisting of Mo, V, W, Pd, Ru, Ta, Nb and Cr; and
(b) reducing the metal oxide on the substrate into the corresponding metal by contacting the film of the metal oxide with a reducing gas at a temperature in the range of from 300 to 1500°C.

Suitable gas phase deposition processes include chemical vapour deposition (CVD) processes and physical vapour deposition (PVD) processes. Suitable processes include, for instance, atmospheric pressure chemical vapour deposition (APCVD), low-pressure chemical vapour deposition processes, plasma enhanced chemical vapour deposition (PECVD), evaporation processes, electron beam evaporation processes, sputtering processes. Preferably, the gas phase deposition process is a physical vapour deposition process, more preferably an evaporation process.

Suitably, the gas phase deposition process is carried out in vacuum, more preferably in high vacuum. In the gas phase deposition process the metal oxide is suitably evaporated at a temperature in the range of from 300 to 1000°C, preferably at a temperature in the range of from 400 to 900°C, and more preferably at a temperature in the range of from 500 to 750°C.

Preferably, step (b) is carried out at a temperature in the range of from 300 to 1200°C, more preferably at a temperature in the range of from 350 to 750°C.

Step (b) can suitably be carried out at elevated or reduced pressure. The pressure applied will depend on the type of reactor system used. Preferably, step (b) will be carried out at reduced pressure.

In the process according to the present invention use is made of a reducing gas. Suitable reducing gases include hydrogen, methane or ammonium. Preferably, the reducing gas comprises hydrogen in a range of from 5 to 100 weight percent. More preferably, the reducing gas comprises pure hydrogen.

The metal to be used in accordance with the present invention is selected from the group consisting of Mo, V, W, Pd, Ru, Ta, Nb and Cr. Preferably, the metal is chosen from Mo, V and W. If the metal is molybdenum, the metal oxide comprises MoO2 or MoO3. More preferably, the metal oxide comprises MoO3.

The metal film obtained in accordance with the present invention can suitably have a thickness in the range of from 50 nm to 5 µm, preferably in the range of from 100 nm to 1 µm.

Suitably, the substrate is a substrate for use in a solar cell. Such substrates are well known and include for instance glass, ceramic glass, polymer foils, steel foils and titanium foils. Preferably, the substrate comprises glass or ceramic glass.

The substrate can suitably have a thickness in the range of from 0.01 mm to 10 mm.

The present invention also relates to a substrate onto which a metal film is applied, which metal film is obtainable by the process according to the present invention.

Suitably, an active layer can be applied onto the metal film in the process according to the present invention. Suitably, the active layer comprises a chalcogenite type of material. The active layer can for instance comprise CuInS2 or CuInSe2. The active layer can be applied onto the metal film by means of any of the known deposition processes, including processes such as hot spraying, atomic layer deposition (ALD), sol/gel deposition, atmospheric pressure chemical vapour deposition (APCVD), low pressure chemical vapour deposition (LPCVD) or a plasma enhanced chemical vapour deposition (PECVD) process. Also, suitably use can be made of various evaporation processes.

To ensure good performance of the active layer a buffer layer can suitably be applied onto the active layer. Such a buffer layer can, for instance, be made of CdS. The buffer can suitably have a thickness in the range of from 30 nm to 150 nm, preferably in the range of from 40 nm to 75 nm. The buffer layer can suitably be applied onto the active layer by means of a chemical bath deposition process. On the buffer layer suitably a layer of intrinsic zinc oxide can be applied. Such a layer can, for example, be applied onto the buffer layer by means of any of the known deposition processes, including processes such as hot spraying, atomic layer deposition (ALD), sol/gel deposition, atmospheric pressure chemical vapour deposition (APCVD), low pressure chemical vapour deposition (LPCVD) or a plasma enhanced chemical vapour deposition (PECVD) process. Also, suitably use can be made of evaporation processes. Preferably, the layer of intrinsic zinc oxide applied onto the buffer layer (or active layer) by means of a physical vapour deposition process, more preferably a sputtering process.

Suitably, a transparent conductive oxide layer can be applied onto the layer of intrinsic zinc oxide. The transparent conductive oxide layer can suitably be applied onto the buffer layer or, if applicable, onto the active layer by means of any of the deposition processes mentioned hereinbefore. The transparent conductive oxide layer is preferably applied onto the layer of intrinsic zinc oxide (or active layer) by means of a physical vapour deposition process, more preferably a sputtering process.

The transparent conductive oxide layer may comprise one or more transparent conductive oxides selected from the group consisting of zinc oxide, tin oxide, zinc stannate, and/or indium tin oxide. Preferably, the transparent conductive oxide layer comprises zinc oxide and/or tin oxide. The transparent conductive oxide can be doped with a material such as aluminium, fluorine, gallium or boron. More preferably, the transparent conductive oxide layer comprises Al-doped zinc oxide (ZnO:Al). The thickness of the transparent conductive oxide layer can suitably be in the range of from 100 nm to 5 µm, preferably in the range of from 200 nm to 800 nm.

In turn, a barrier layer or substrate layer can suitably be applied onto the transparent conductive oxide layer. The composition of such barrier layers and substrate layers are as such well known to the person skilled in the art. Such a barrier layer or substrate layer can suitably be made of SiO2 or glass.

## Claims

1. A process for preparing a metal film on a substrate, comprising the steps of:
(a) depositing a film of a metal oxide on a substrate by means of a gas phase deposition process, which metal is selected from the group consisting of Mo, V, W, Pd, Ru, Ta, Nb and Cr; and
(b) reducing the metal oxide on the substrate into the corresponding metal by contacting the film of the metal oxide with a reducing gas at a temperature in the range of from 300 to 1500°C.

2. A process according to claim 1, wherein in the gas phase deposition process is a physical vapour deposition process.

3. A process according to claim 2, wherein the gas phase deposition process is an evaporation process.

4. A process according to any one of claims 1-3, wherein the gas phase deposition process is carried out in vacuum.

5. A process according to claim 4, wherein the gas deposition process is carried out in vacuum.

6. A process according to any one of claims 1-5, wherein in the gas phase deposition process the metal oxide is evaporated at a temperature is in the range of from 300 to 1000°C.

7. A process according to any one of claims 1-6, wherein in step (b) the temperature is in the range of from 300 to 1200°C.

8. A process according to any one of claims 1-7, wherein in step (b) a reduced pressure is applied.

9. A process according to any one of claims 1-8, wherein the reducing gas comprises hydrogen or a hydrogen-containing gas.

10. A process according to any one of claims 1-9, wherein the metal is selected from the group consisting of Mo, V and W.

11. A process according to any one of claims 1-10, wherein the metal is Mo.

12. A process according to any one of claims 1-11, wherein the metal oxide is MoO3.

13. A process according to any one of claims 1-12, wherein the substrate is a substrate for use in a solar cell.

14. A process according to any one of claims 1-13; wherein the substrate comprises glass or ceramic glass.

15. A process according to any one of claim 1-14, wherein an active layer is applied onto the metal film.

16. A process according to claim 15, wherein a buffer layer is applied onto the active layer.

17. A process according to claim 16, wherein a layer of intrinsic zinc oxide is applied onto the buffer layer.

18. A process according to claim 17, wherein a transparent conductive oxide layer is applied onto the layer of intrinsic zinc oxide.

19. A process according to claim 18, wherein a barrier layer or substrate layer is applied onto the transparent conductive oxide layer.

20. A substrate onto which a metal film is applied, which metal film is obtainable by the process according to any one of claims 1-14.

21. A solar cell comprising at least a transparent conductive oxide layer, an active layer, a substrate and a back electrode layer applied onto the substrate, which back electrode layer comprises the metal film obtainable by the process according any one of claims 1-14.

22. A solar cell according to claim 21 comprising in addition a buffer layer and a layer of intrinsic zinc oxide.
